# EUROPEAN PATENT SPECIFICATION

(11) **EP 0 293 156 B1**
(45) Date of publication and mention of the grant of the patent: **27.07.1994**
(21) Application number: 88304655.9
(22) Date of filing: 23.05.1988
(51) Int. Cl.: H03K 5/15, H03K 19/017, H01L 27/146, H01L 31/11, H04N 3/15

(54) **Scan circuit**
Abtastungsschaltung
Circuit de balayage

(30) Priority: 25.05.1987 JP 125925/87; 25.05.1987 JP 125926/87
(43) Date of publication of application: 30.11.1988
(73) Proprietor: CANON KABUSHIKI KAISHA, Tokyo (JP)
(72) Inventor: Hashimoto, Seiji, Yokohama-shi Kanagawa-ken (JP); Harada, Tadanori, Tokorozawa-shi Saitama-ken (JP)
(74) Representative: Beresford, Keith Denis Lewis

(56) References cited:
- GB-A- 2 022 953
- US-A- 3 786 281

## Description

The present invention relates to a drive selection circuit that outputs scan pulses in response to drive pulses. It relates in particular to a photosensing pick-up apparatus including such a drive selection circuit.

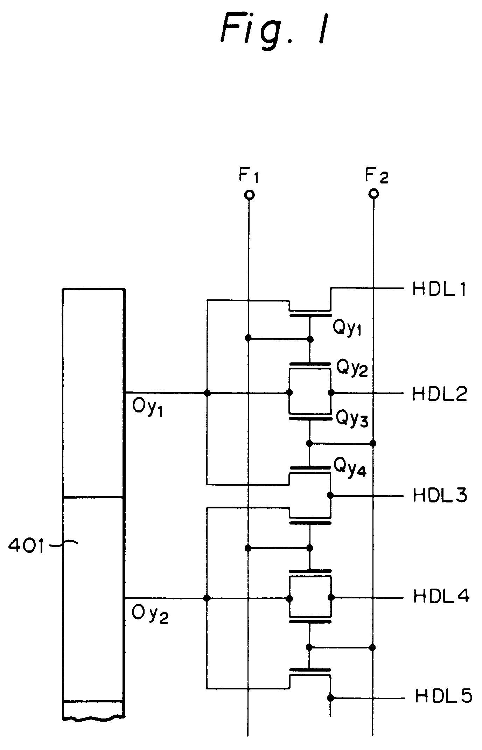

Fig. 1 is a schematic circuit diagram of a solid state image pickup apparatus using a conventional scan circuit.

In the diagram, respective output terminals of a scan circuit 401 are connected to horizontal lines HDL₁, HDL₂, and HDL₃, and to horizontal lines HDL₃, HDL₄, HDL₅, ...through transistors Qy₁ to Qy₄.

A signal F₁ to select odd number fields is input to gate electrodes of the transistors Qy₁ and Qy₂. A signal F₂ to select even number fields is input to gate electrodes of the transistors Qy₃ and Qy₄. Namely, the transistors Qy₁ to Qy₄ constitute an interlacing circuit.

When the signal F₁ is input, scan pulses Oy₁, Oy₂, ... are sequentially output to the horizontal lines HDL₁ and HDL₂, horizontal lines HDL₃, and HDL₄, ... through the transistors Qy₁ and Qy₂.

On the other hand, when the signal F₂ is input, the scan pulses 0y₁, Oy₂, ... are sequentially output to the horizontal lines HDL₂ and HDL₃, the HDL₄, and HDL₅, ... through the transistors Qy₃ and Qy₄.

However, in the foregoing image pickup apparatus using the conventional scan circuit, the signals Oy₁ and Oy₂ are transferred to the horizontal lines HDL through the transistors Qy₁ and Qy₂ and the transistors Qy₃ and Qy₄ of the interlacing circuit. Therefore, there are problems such that a voltage drop due to a threshold value voltage Vth of the transistor Qy occurs and the dynamic range is narrowed, so that the picture quality deteriorates.

To solve this problem, in Japanese Patent Gazette No. 61-61586, a vertical buffer circuit to compensate a voltage level of the scan pulse Oy is provided. However, since the buffer circuit is separately provided, the number of elements constituting the vertical scan circuit increases and also the buffer circuit has a bootstrap capacitance. Thus, there is a problem such that it is difficult to reduce the area of the elements.

On the other hand, since two horizontal lines are simultaneously driven, the conventional drive circuit cannot be used in the image pickup devices in which a signal is readout by every one vertical line. Namely, the conventional constitution has problems such that there is a limitation in driving manner and this constitution can be applied to only the limited driving method.

A drive selection circuit which can support various kinds of driving modes such as interlacing scan, non-interlacing scan and the like is needed.

Finally reference is made to United States Patent No. 3786281 which also describes a photosensing pick-up apparatus including a drive selection circuit. Features of this latter circuit which are common to the circuit of the present invention are set out in the statement of invention and in the preamble of claim 1 presented hereinbelow.

In accordance with this invention there is provided a drive selection circuit that outputs scan pulses, said circuit comprising:
a ripple shift register having a plurality of output stages; and
a switch array including a plurality of first transistors and a plurality of second transistors, wherein:
each first transistor and each second transistor has a gate connected to a common respective output stage of said ripple-shift register;
said first transistors are each connected between a common first drive voltage line and a respective selection line output of said switch array; and
said second transistors are each connected between a common second drive voltage line and a respective selection line output of said switch array;
which circuit is characterised by:
a plurality of third transistors each having a gate connected to said common respective output stage, and each said third transistor being connected between a common third drive voltage line and the respective selection line output which is connected to that first transistor the gate of which is connected to the next output stage, of said ripple-shift register.

With this constitution, even when a plurality of drive lines are scanned, each line can be independently driven and various kinds of driving modes such as interlacing scan, non-interlacing scan, and the like of a plurality of lines can be easily realised.

Other features of the present invention will become apparent from the following detailed description and the appended claims with reference to the accompanying drawings.

In the accompanying drawings:
Fig. 1 is a schematic circuit diagram of a drive section in a solid state image pickup apparatus using a conventional scan circuit;
Fig. 2A is a partial circuit diagram of a ripple shift register which can be employed in a photosensing pick-up apparatus according to the present invention;
Fig. 2B is a voltage waveform diagram for explaining operation of the ripple shift register of the preceding figure;
Fig. 3 is a partial circuit diagram of a ripple shift register of an alternative construction;
Fig. 4 is a voltage waveform diagram for explaining the operation of the register of Fig. 3;
Fig. 5 is a schematic circuit diagram of a photosensing pick-up apparatus including a drive selection circuit which is in accordance with the present invention;
Fig. 6 is a timing chart for explaining the operation of the apparatus of Fig. 5;
Fig. 7 is a schematic circuit diagram of another example of photosensing pickup apparatus using a drive selection circuit of an alternative construction, also in accordance with the present invention.
Fig. 8 is a timing chart for explaining the operation of the apparatus of Fig. 7;
Fig. 9 is a schematic cross sectional view showing an example of a photoelectric converting cell which is used in a photosensing solid stage image pickup apparatus;
Fig. 10A is an equivalent circuit diagram of this photoelectric converting cell;
Fig. 10B is a voltage waveform diagram for explaining the operation of the circuit of Fig. 10A;
Fig. 11 is a schematic circuit diagram of an image pickup apparatus using this photoelectric converting cell; and
Fig. 12 is a timing chart for schematically explaining the operation of the image pickup apparatus of Fig. 11.

Embodiments of this invention will be described hereinbelow and reference will be made to the aforesaid drawings. The following description is given by way of example only.

By way of introduction, details of ripple shift registers which may be employed in preferred embodiments of the apparatus will first be given.

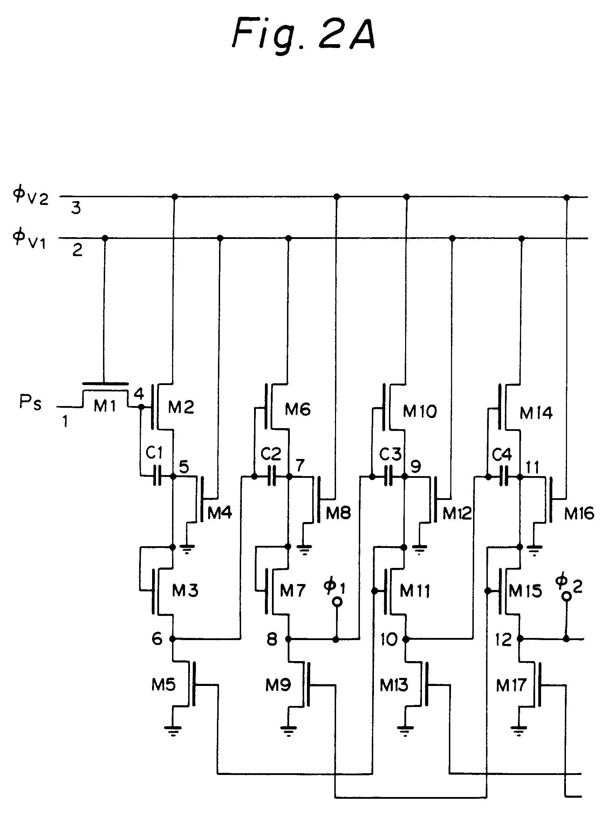

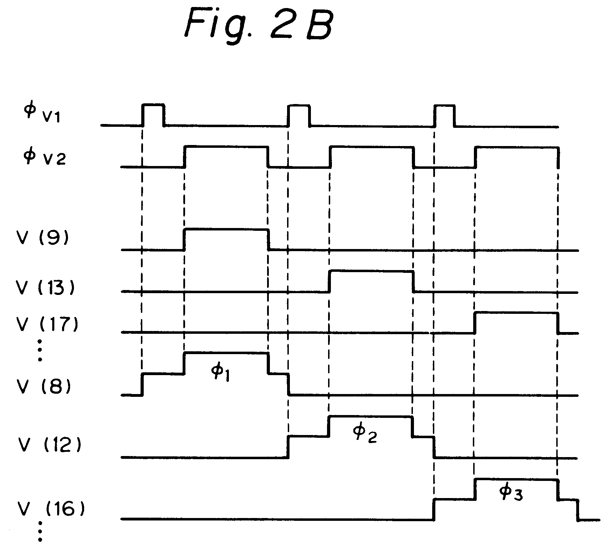

Fig. 2A is a partial circuit diagram of a first example of ripple shift register and Fig. 2B is a voltage waveform diagram for explaining its operation.

As shown in Fig. 2A, n unit circuits are provided and scan pulses φ₁ to φₙ are sequentially output from these unit circuits. The potential of each section in Fig. 2A is expressed as V(i) where the reference number (i) identifies the corresponding unit circuit.

In the diagram, in the first unit circuit when a pulse 0v₁ rises after a Pₛ has been applied, a transistor M₁ is made conductive and a potential V(4) rises. Since the potential V(4) is the gate potential of a transistor M₂, the transistor M₂ shows a conductance corresponding to the potential V(4).

Subsequently, when the pulse φᵥ₁ falls and a pulse φᵥ₂ rises, the potential V(5) increases through the transistor M₂. The increase in the potential V(5) is fed back to a gate of the transistor M₂ via a capacitor C₁, thereby increasing the potential V(4) due to a bootstrap effect. The increase in the potential V(4) acts so as to raise the conductance of the transistor M₂. Therefore, the pulse φᵥ₂ passes, while a voltage drop hardly occurs due to the transistor M₂. This pulse is transmitted through a transistor M₃, thereby increasing the potential V(6).

Since the potential V(6) is the gate potential of a transistor M₆, a conductance of the transistor M₆ rises in correspondence to the potential V(6).

When the pulse φᵥ₁ subsequently rises, the potential V(7) increases through the transistor M₆. The potential V(6) further rises due to the increase in the potential V(7). Since the increase in the potential V(6) acts so as to enhance the conductance of the transistor M₆, the pulse φᵥ₁ allows the potential V(8) to be raised through the transistors M₆ and M₇ (refer to Fig. 2B). Therefore, a transistor M₁₀ exhibits the conductance corresponding to the gate potential V(8).

Next, when the pulse φᵥ₂ rises, the transistor M₈ is turned on and the potential V(7) is reset to the earth potential and the transistor M₇ is turned off. Thus, the portion of the potential V(8) is set into the floating state.

At the same time, since the pulse φᵥ₂ rises, the potential V(9) rises through the transistor M₁₀. Increases in the potential V(9) further increases potential V(8).

If such a change in the potential V(8) is used as a scan pulse φ₁, a scan pulse at a high voltage can be obtained.

Next, the potential V(8) is reset by the pulse φᵥ₁ and at the same time, the potential V(12) rises and, further, increases by the subsequent pulse φᵥ₂. The potential V(12) is used as a scan pulse φ₂. In a manner similar to the above, scan pulses φ₃ to φₙ at a high voltage level are successively output synchronously with the pulses φᵥ₂.

In Fig. 2B, by properly setting the timings for the drive pulses φᵥ₁ and φᵥ₂, the waveforms of the scan pulses φ₁ to φₙ can be made to approximate a square waveform.

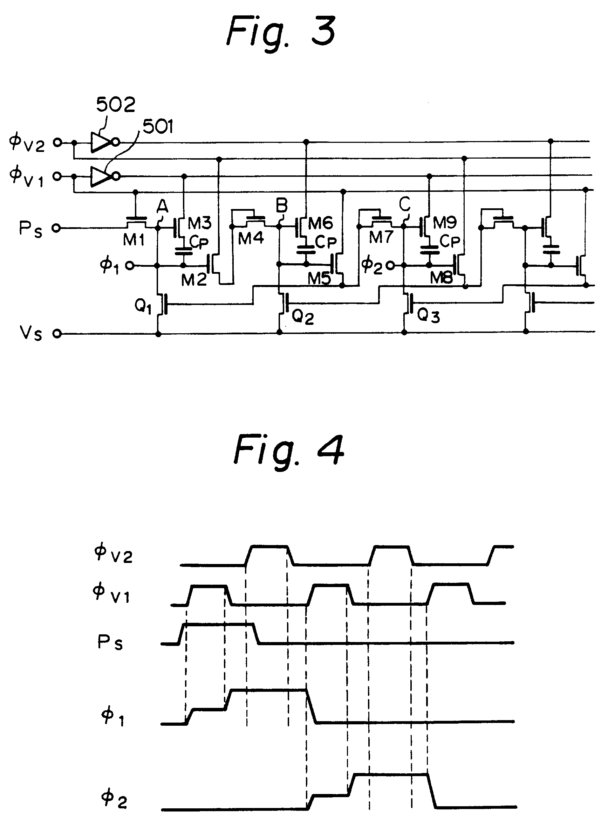

Fig. 3 is a partial circuit diagram of another construction of ripple shift register which can be adapted. Fig. 4 is a voltage waveform diagram for explaining the operation thereof.

Referring to Fig. 2B, firstly, a transistor M₁ is turned on and a potential V(A) rises by a start pulse Pₛ and a drive pulse φᵥ₁. Transistors M₂ and M₃ conduct.

Subsequently, when the drive pulse φᵥ₁ falls, an output of an inverter 501 rises. Consequently, a voltage is applied to a capacitor Cₚ through the transistor M₃ and the potential V(A) further rises.

Therefore, if such a change in the potential V(A) is used as a scan pulse φ₁, the scan pulse at a high voltage can be derived in a manner similar to the first example. In a manner similar to the above, scan pulses φ₂ to φₙ at a high voltage level can be successively output synchronously with the drive pulses φᵥ₁ and φᵥ₂.

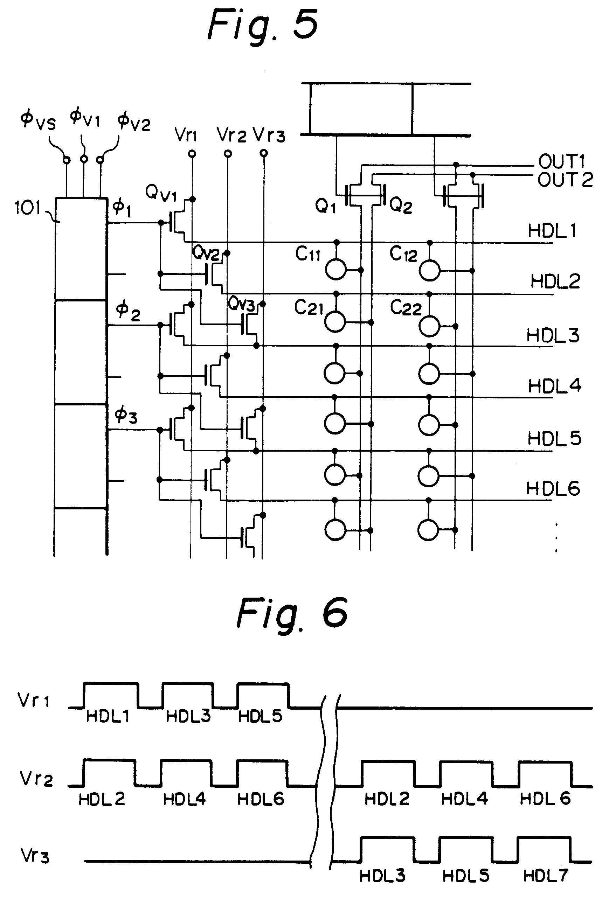

Fig. 5 is a schematic circuit diagram of a photosensitive image pickup apparatus including the ripple shift register just described. Fig. 6 is a timing chart for explaining the operation thereof.

As shown in Fig. 5, this image pickup apparatus comprises photoelectric converting cells C₁₁, C₁₂, ... which are arranged in a two-dimensional array and driven each row by each one of several horizontal lines HDL₁, HDL₂, HDL₃, ... Photoelectric conversion signals are read out through vertical lines and transistors Q₁ and Q₂.

In this embodiment, gate electrodes of three transistors Qᵥ₁ to Qᵥ₃ are connected to the output terminals of a scan circuit 101, respectively.

Each transistor Qᵥ₁ transfers a drive voltage Vᵣ₁ to a respective one of each of the horizontal lines HDL₁, HDL₃, HDL₅, .... Each transistor Qᵥ₂ transfers a drive voltage Vᵣ₂ to a respective one of each of the horizontal lines HDL₂, HDL₄, HDL₆, .... Each respective transistor Qᵥ₃ transfers a drive voltage Vᵣ₃ to the respective horizontal line HDL₃, HDL₅, HDL₇, ....

In such a circuit arrangement, the scan circuit 101 sequentially outputs the scan pulses φ₁, φ₂, ... in response to pulses φᵥ₁ and φᵥ₂. Therefore, by applying the drive voltages Vᵣ₁ to Vᵣ₃ by a proper combination, the image pickup device can be scanned in a desired mode.

For example, as shown in Fig. 6, by applying the drive voltage Vᵣ₁ and Vᵣ₂ in the odd number fields, the horizontal lines HDL₁ and HDL₂, and HDL₃ and HDL₄, ... are driven and by applying the drive voltage Vᵣ₂ and Vᵣ₃ in the even number fields, the HDL₂ and HDL₃, and HDL₄ and HDL₅, ... are driven. In this manner, the interlacing scan of the two line driving type can be accomplished.

On the other hand, if the drive voltages Vᵣ₁ and Vᵣ₂ and the drive voltages Vᵣ₂ and Vᵣ₃ are applied at different timings which are deviated from each other, the vertical line of the image pickup device can be also set to a single vertical line.

Even though such a vertical buffer circuit is provided, the output of the scan circuit 101 can be set to a high voltage level, and the transistors Qᵥ₁ to Qᵥ₃ can be set to a sufficient high conductance The drive voltages Vᵣ₁ to Vᵣ₃ can be transferred to the horizontal lines HDL without having to reduce the drive voltages Vᵣ₁ to Vᵣ₃.

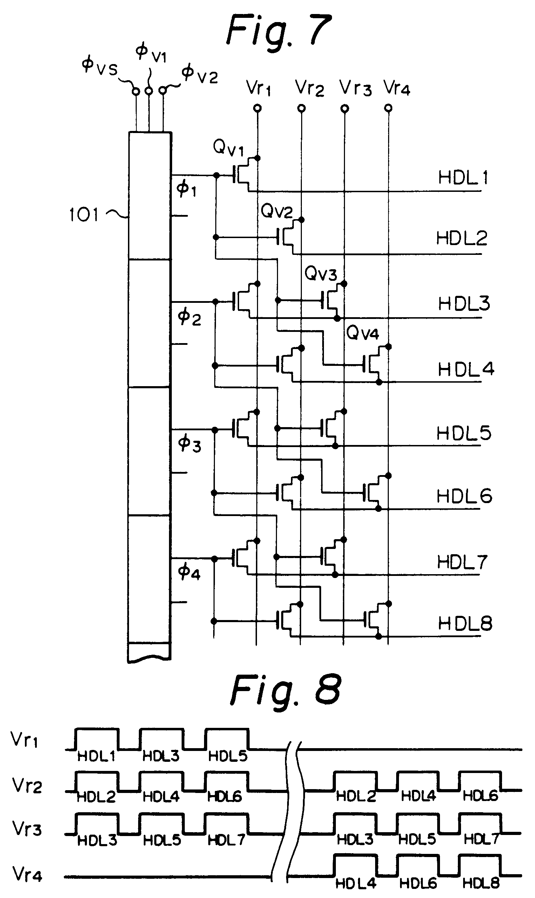

Fig. 7 is a schematic circuit diagram of another example of apparatus.

Fig. 8 is a timing chart for explaining the operation thereof.

In this manner, by providing the transistors Qᵥ₁ to Qᵥ₄ at the respective output terminals of the scan circuit 101 and by combining the drive voltages Vᵣ₁ to Vᵣ₄ as shown in the timing chart, the interlacing scan of the three-line driving type can be also accomplished.

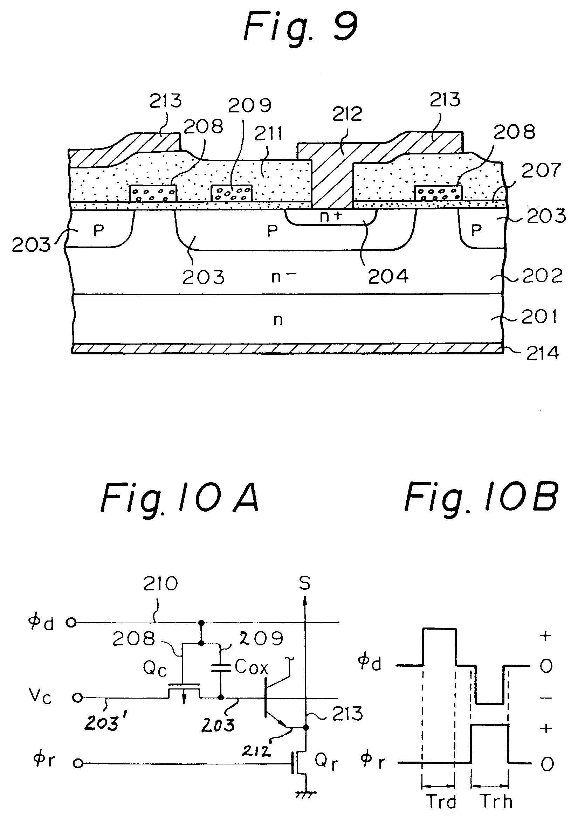

Fig. 9 is a schematic cross sectional view of a photoelectric converting cell which can be used in the solid state image pickup apparatus just described.

In the diagram, an n⁻ layer 202 serving as a collector region is formed on an n type silicon substrate 201 by the epitaxial growth. A p base region 203 is formed in the n⁻ layer 202. An n⁺ emitter region 204 is further formed in the p base region 203. In this manner, a bipolar transistor is constituted.

The p base region 203 is two-dimensionally arranged. The cells in the horizontal direction are separated from the cells in the vertical direction by a device separating region. Although not shown, the device separating region comprises an oxide film formed by the LOCOS oxidation and an n⁺ region formed under the oxide film.

On the other hand, a gate electrode 208 is formed between horizontally neighboring p base regions 203 through an oxide film 207. Therefore, a p channel MOS transistor Q_{c} in which the adjacent p base regions 203 are used as source and drain regions is constituted.

This MOS transistor is the normally OFF type and is set to the OFF state when the potential of the gate electrode 208 is the earth potential or positive potential. Therefore, the p base regions 203 between the adjacent cells are electrically isolated. On the contrary, when the potential of the gate electrode 208 is a negative potential which exceeds a threshold value potential Vₜₕ, the MOS transistor is set to the ON state, so that the p base regions 203 of the respective cells are mutually made conductive.

The gate electrodes 208 are commonly connected to the drive line every row in the horizontal direction. Further, capacitors 209 to control the potentials of the p base regions 203 are also similarly connected to the drive line. The drive line extends in the horizontal direction on the oxide film serving as the device separating region.

Further, after a transparent insulative layer 211 was formed, an emitter electrode 212 is formed. The emitter electrodes 212 are connected to a vertical line 213 every column. A collector electrode 214 is formed on the back surface of the substrate 201 through an ohmic contact layer.

Fig. 10A is an equivalent circuit diagram of the photoelectric converting cell. Fig. 10B is a voltage waveform diagram for explaining the operation thereof.

It is now assumed that carriers (in this case, holes) generated by the incident light are accumulated in the p base region 203. It is also assumed that a negative voltage V_{c} is applied to a terminal of transistor Q_{c} and a positive voltage is applied to the collector electrode 214.

In this state, pulses φ_{d} of a positive voltage are applied to a drive line 210 for only a period of time T_{rd}. Thus, the potential of the p base region 203 rises through a capacitor Cₒₓ and the signal is read out to the emitter electrode 212 as mentioned above.

Subsequently, pulses φ_{d} of a negative voltage are applied to the drive line 210 for only a period of time Tᵣₕ. Thus, the p channel MOS transistor Q_{c} is turned on and the base potential is reset to the voltage V_{c} and the resetting operation is completed On the other hand, by setting a pulse φᵣ to the high level, the transistor Qᵣ is turned on, thereby resetting the vertical line 213.

As already mentioned above, as the resetting operation, after the MOS transistor Q_{c} was turned on, the pulse φ_{d} of a positive voltage can be also applied while the emitter electrode 212 is grounded. In this case, there is no need to set the voltage V_{c} to a negative voltage but can be set to the earth voltage or positive voltage.

After completion of the foregoing resetting operation, the accumulating operation is started. Similar operations are repeated.

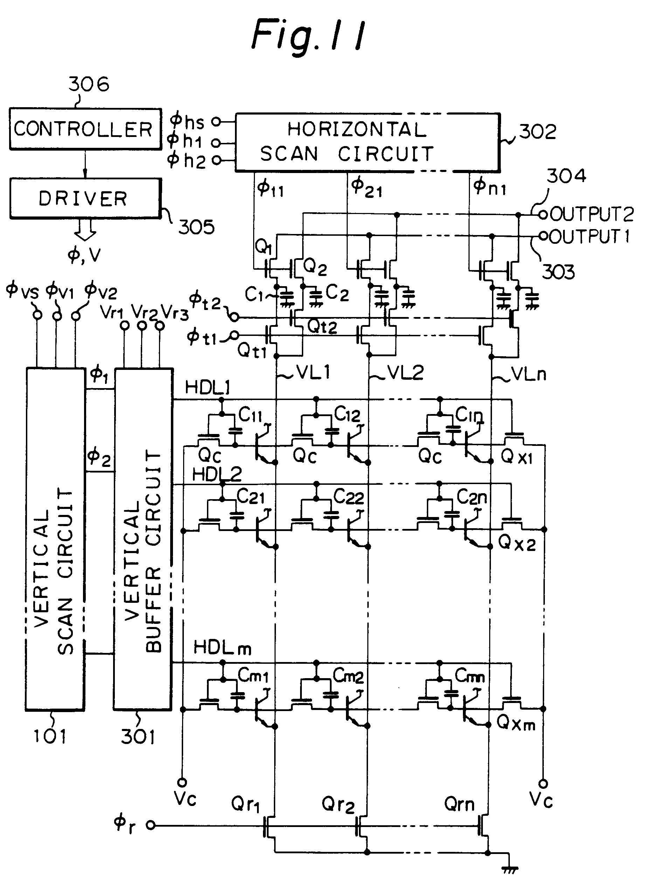

Fig. 11 is a schematic circuit diagram of an image pickup apparatus using the foregoing photoelectric converting cell.

In this apparatus, m x n photoelectric converting cells are arranged as a two dimensional array.

In the cells C₁₁ to C₁ₙ, C₂₁ to C₂ₙ, ... on the horizontal lines, the gate electrodes 208 of the MOS transistor Q_{c} are commonly connected to the drive lines HDL₁ to HDLₘ, respectively.

The drive lines HDL₁ to HDLₘ are connected to a vertical buffer circuit 301. The scan pulses φ₁ to φₘ are input to the vertical buffer circuit 301 from the vertical scan circuit 101,

The MOS transistors Q_{c} in each of which the p base regions 203 in each cell are used as source and drain regions are serially connected every horizontal line. The p regions to form the MOS transistor Q_{c} are respectively formed in the cells C₁₁ to Cₘ₁ arranged at the edge line. On the other hand, MOS transistors Qₓₗ to Qₓₘ are respectively serially connected to the cells C₁ₙ to Cₘₙ. A constant voltage V_{c} is applied to both ends.

The emitter electrodes in the cells C₁₁ to Cₘ₁, C₁₂ to Cₘ₂, ... in the vertical direction are commonly connected to vertical lines VL₁ to VLₙ, respectively. The vertical lines are grounded through reset transistors Qᵣ₁ to Qᵣₙ. A reset pulse φᵣ is commonly input to the gate electrodes of the transistors Qᵣ₁ to Qᵣₙ.

The vertical lines VL₁ to VLₙ are connected to capacitors C₁ and C₂ through transistors Qₜ₁ and Qₜ₂, respectively. The pulses φ₁ and φ₂ are input to the gate electrodes of the transistors Qₜ₁ and Qₜ₂.

Further, the capacitors C₁ and C₂ are connected to signal lines 303 and 304 through the transistors Q₁ and Q₂, respectively. Scan pulses φ₁₁ to φₙ₁ of a horizontal scan circuit 302 are input to the gate electrodes of the transistors Q₁ and Q₂, respectively.

Various kinds of pulses φ, voltages V, and the like to drive the image pickup apparatus are supplied from a driver 305. The driver 305 is controlled by a controller 306.

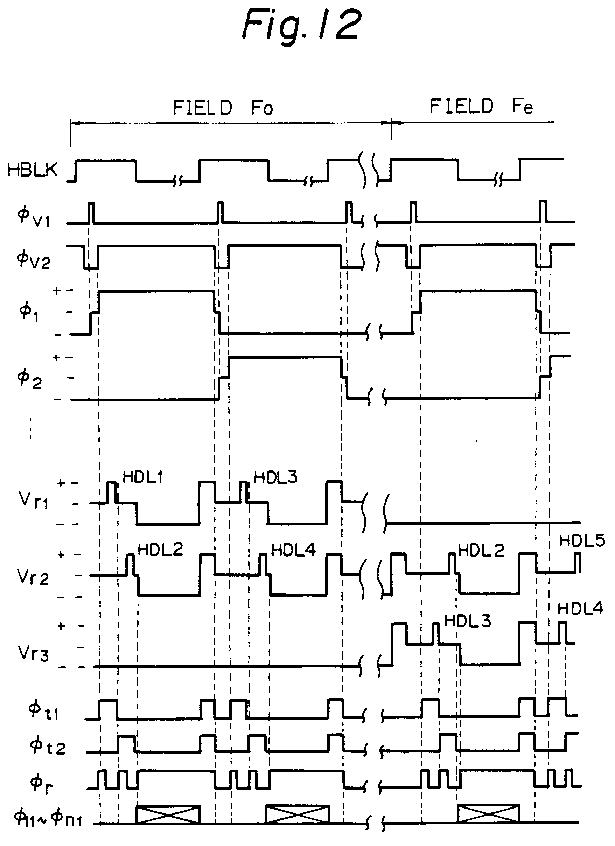

Fig. 12 is a timing chart for schematically explaining the operation of the image pickup apparatus.

In the odd number fields Fₒ, when the pulses φᵥ₁ and φᵥ₂ are input to the vertical scan circuit 101, the scan pulse φ₁ rises. The scan pulse φ₁ is set to a high voltage.

Thus, the vertical buffer circuit 301 outputs input voltages Vᵣ₁ and Vᵣ₂ to the horizontal lines HDL₁ and HDL₂, respectively.

Simultaneously with the rising of the pulse φᵥ₂, the pulses φₜ₁ and φᵣ rise and the transfer transistor Qₜ₁ and reset transistor Qᵣ are turned on, thereby clearing the vertical lines VL and capacitor C₁.

Subsequently, after the reset transistor Qᵣ has been turned off, the input voltage Vᵣ₁ is set to a positive voltage and the reading operations of the cells C₁₁ to C₁ₙ on the horizontal line HDL₁ are executed. The readout signals are stored into the capacitor C₁ through the transfer transistor Qₜ₁, respectively.

Next, when the pulses φₜ₂ and φᵣ rise, the transfer transistor Qₜ₂ and reset transistor Qᵣ are turned on, thereby clearing the capacitor C₂ and vertical lines VL.

Subsequently, the input Vᵣ₂ is set to a positive voltage and the reading operations of the cells C₂₁ to C₂ₙ on the horizontal line HDL₂ are executed. The readout signals are stored into the capacitor C₂ through the transfer transistor Qₜ₂.

The foregoing operations are performed within a horizontal blanking period HBLK. Next, the sensor signals of the first and second rows which were accumulated in the capacitors C₁ and C₂ within the effective horizontal period are scanned and output.

Namely, the transistors Q₁ and Q₂ are sequentially turned on by the scan pulses φ₁₁ to φₙ₁ which are successively output from the horizontal scan circuit 302. The signals stored in the capacitors C₁ and C₂ are read out and output to the signal lines 303 and 304.

In parallel with those operations, the pulse φᵣ rises and the transistor Qᵣ is turned on, thereby grounding the vertical lines VL. On the other hand, the input voltages Vᵣ₁ and Vᵣ₂ are set to a negative voltage, thereby resetting the cells of the first and second rows. That is, the MOS transistor Q_{c} of each cell are turned on and each base potential is set to a common potential.

Next, the input voltages Vᵣ₁ and Vᵣ₂ are set to a positive voltage, thereby resetting the base regions 203 which were reset to a common potential. In other words, since the emitter electrodes of the cells are grounded through the vertical lines VL, when a positive voltage is applied to capacitors Cₒₓ, the circuit between the base and emitter is forwardly biased, so that the carriers accumulated in the base region 203 are extinguished in a manner similar to the reading operations.

After completion of the resetting operation in this manner, the cells of the first and second rows start the accumulating operation.

In a manner similar to the above, the reading and resetting operations of the third and fourth rows, the fifth and sixth rows, ... in the odd number fields Fₒ are sequentially executed by the pulses φᵥ₁ and φᵥ₂.

In the even number fields Fₑ, the reading and resetting operations of the second and third rows, the fourth and fifth rows, ... are successively performed by the input Vᵣ₂ and Vᵣ₃.

Since drive signals are supplied to the drive lines in a desired mode on the basis of the scan output of the scan circuit and a desired combination of the drive signals, even when a plurality of drive lines are scanned, they can be independently driven. Various kinds of driving modes such as interlacing scan, non-interlacing scan, and the like of a plurality of lines can be easily performed.

## Claims

1. Drive selection circuit (301) that outputs scan pulses, said circuit comprising:
a ripple shift register (101) having a plurality of output stages (φ₁, φ₂, φ₃); and
a switch array (Q_{V1} to Q_{V3}) including a plurality of first transistors (Q_{V1}) and a plurality of second transistors (Q_{V2}), wherein:
each first transistor (Q_{V1}) and each second transistor (Q_{V2}) has a gate connected to a common respective output stage (φ₁, φ₂, φ₃, ...) of said ripple-shift register (101);
said first transistors (Q_{V1}) are each connected between a common first drive voltage line (Vᵣ₁) and a respective selection line output (HDL1, HDL3, HDL5, ...) of said switch array (Q_{V1} to Q_{V3}); and
said second transistors (Q_{V2}) are each connected between a common second drive voltage line (Vr₂) and a respective selection line output (HDL2, HDL4, HDL6, ....) of said switch array (Q_{V1} to Q_{V3});
which circuit is characterised by:
a plurality of third transistors (Q_{V3}) each having a gate connected to said common respective output stage (φ₁ φ₂, φ₃, ...), and each said third transistor (Q_{V3}) being connected between a common third drive voltage line (Vᵣ₃) and the respective selection line output (HDL3, HDL5,...) which is connected to that first transistor (Q_{V1}) the gate of which is connected to the next output stage (φ₂, φ₃) of said ripple-shift register (101).

2. A circuit as claimed in claim 1 comprising a drive voltage source (305) connected to said first, second and third drive voltage lines (Vᵣ₁, Vᵣ₂, Vᵣ₃) to apply first, second and third drive voltage signals (Vᵣ₁, Vᵣ₂, Vᵣ₃) respectively thereto, which source (305) is operable such that for odd field said first and second drive voltage signals (Vᵣ₁, Vᵣ₂) consist in respective in-phase sequences of regular pulses HDL1, HDL3, HDL5; HDL2, HDL4, HDL6) while said third drive voltage signal (Vᵣ₃) is quiescent, and for even field said first drive voltage signal (Vᵣ₁) is quiescent while said second and third drive voltage signals (Vᵣ₂, Vᵣ₃) consist in respective in-phase sequences of regular pulses (HDL2, HDL4, HDL6; HDL3, HDL5, HDL7).

3. A circuit as claimed in claim 1 further characterised by:
a plurality of fourth transistors (Qᵥ₄) each having a gate connected to said common respective output stage (φ₁, φ₂, φ₃, ...) and each fourth transistor (Qᵥ₄) being connected between a common fourth drive voltage line (Vᵣ₄) and the respective selection output (HDL4, HDL6, HDL8, ...) which is connected to that second transistor (Qᵥ₂) the gate of which is connected to the next output stage (φ₂, φ₃, ...) of said ripple-shift register (101).

4. A circuit as claimed in claim 3 comprising a drive voltage source (305) connected to said first, second, third and fourth drive voltage lines (Vᵣ₁, Vᵣ₂, Vᵣ₃, Vᵣ₄) to apply first, second, third and fourth drive voltage signals (Vᵣ₁, Vᵣ₂, Vᵣ₃, Vᵣ₄) respectively thereto, which source (305) is operable such that for odd field said first, second and third drive voltage signals (Vᵣ₁, Vᵣ₂, Vᵣ₃) consist in respective in-phase sequences of regular pulses (HDL1, HDL3, HDL5; HDL2, HDL4, HDL6; HDL3, HDL5, HDL7) while said fourth drive voltage signal (Vᵣ₄) is quiescent, and for even field said first drive voltage signal (Vᵣ₁) is quiescent while said second, third, and fourth drive voltage signals (Vᵣ₂, Vᵣ₃, Vᵣ₄) consist in respective in-phase sequences of regular pulses (HDL2, HDL4, HDL6; HDL3; HDL5, HDL7; HDL4, HDL6, HDL8).

5. Photosensing pick-up apparatus comprising:
an array of photosensitive cells (C₁₁ to Cₘₙ) arranged by row and by column;
a multiplicity of selecting lines (HDL1, ..., HDLm) connected each to a respective row (C₁₁ to C₁ₙ, ..., Cm1 to Cₘₙ) of said photosensitive cells (C₁₁ to Cₘₙ);
a drive selection circuit (301), as claimed in claim 1, the selection line outputs (HDL1 to HDLm) of which are connected to respective ones of said selecting lines (HDL1 to HDLm);
a first signal source (305) connected to the ripple shift register (101) of said drive selection circuit to supply thereto synchronisation and clocking shift control signals (φ_{VS}, φ_{V1}, φ_{V2}) for scanning said selecting lines (HDL1 to HDLM); and
a second signal source (305) connected to the switch array common drive voltage lines (Vᵣ₁ to Vᵣ₃; Vᵣ₁ to Vᵣ₄) of said drive selection circuit to supply thereto drive voltage signals (Vᵣ₁ to Vᵣ₃; Vᵣ₁ to Vᵣ₃).

## Patentansprüche

1. Treiberauswahlschaltung (301), die Abtastimpulse ausgibt, mit:
einem Wellen-Schieberegister (101) mit einer Vielzahl von Ausgangsstufen (φ₁, φ₂, φ₃); und
einem Schalterfeld (Qᵥ₁ bis Qᵥ₃) mit einer Vielzahl von ersten Transistoren (Qᵥ₁) und einer Vielzahl von zweiten Transistoren (Qᵥ₂), wobei:
jeder erste Transistor (Qᵥ₁) und jeder zweite Transistor (Qᵥ₂) ein mit einer jeweils gemeinsamen Ausgangsstufe (φ₁, φ₂, φ₃, ...) des Wellen-Schieberegisters (101) verbundenes Gate besitzt; jeder der ersten Transistoren (Qᵥ₁) zwischen einer gemeinsamen ersten Treiberspannungsleitung (Vᵣ₁) und einem jeweiligen Auswahlleitungsausgang (HDL1, HDL3, HDL5, ...) des Schalterfelds (Qᵥ₁ bis Qᵥ₃) verbunden ist; und
jeder der zweiten Transistoren (Qᵥ₂) zwischen einer gemeinsamen zweiten Treiberspannungsleitung (Vr₂) und einem jeweiligen Auswahlleitungsausgang (HDL2, HDL4, HDL6, ...) des Schalterfelds (Qᵥ₁ bis Qᵥ₃) verbunden ist;
**wobei die Treiberauswahlschaltung gekennzeichnet ist durch:**
eine Vielzahl von dritten Transistoren (Qᵥ₃), von denen jeder ein mit der jeweils gemeinsamen Ausgangsstufe (φ₁, φ₂, φ₃, ...) verbundenes Gate besitzt, und jeder der dritten Transistoren (Qᵥ₃) zwischen einer gemeinsamen dritten Treiberspannungsleitung (Vᵣ₃) und dem jeweiligen Auswahlleitungsausgang (HDL3, HDL5, ...) verbunden ist, der mit dem ersten Transistor (Qᵥ₁) verbunden ist, dessen Gate mit der nächsten Ausgangsstufe (φ₂, φ₃) des Wellen-Schieberegisters (101) verbunden ist.

2. Schaltung gemäß Anspruch 1, gekennzeichnet durch:
eine Treiberspannungsquelle (305), die mit der ersten, zweiten und dritten Treiberspannungsleitung (Vᵣ₁, Vᵣ₂, Vᵣ₃) jeweils zum Anlegen von ersten, zweiten, und dritten Treibspannungssignalen (Vᵣ₁, Vᵣ₂, Vᵣ₃) verbunden ist,
wobei die Treiberspannungsquelle (305) derart betriebsfähig ist, daß für ein ungerades Feld die ersten und zweiten Treiberspannungssignale (Vᵣ₁, Vᵣ₂) aus jeweils gleichphasigen Folgen von regelmäßigen Impulsen (HDL1, HDL3, HDL5; HDL2, HDL4, HDL6) bestehen, während das dritte Treiberspannungssignal (Vᵣ₃) in Ruhe ist, und, daß für ein gerades Feld das erste Treiberspannungssignal (Vᵣ₁) in Ruhe ist, während die zweiten und dritten Treiberspannungssignale (Vᵣ₂, Vᵣ₃) aus jeweils gleichphasigen Folgen von regelmäßigen Impulsen (HDL2, HDL4, HDL6; HDL3, HDL5, HDL7) bestehen.

3. Schaltung gemäß Anspruch 1,
**gekennzeichnet durch**
eine Vielzahl von vierten Transistoren (Qᵥ₄), von denen jeder ein mit der jeweils gemeinsamen Ausgangsstufe (φ₁, φ₂, φ₃, ...) verbundenes Gate besitzt, und jeder vierte Transistor (Qᵥ₄) zwischen einer gemeinsamen vierten Treiberspannungsleitung (Vᵣ₄) und dem jeweiligen Auswahlausgang (HDL4, HDL6, HDL8, ...) verbunden ist, der mit dem zweiten Transistor (Qᵥ₂) verbunden ist, dessen Gate mit der nächsten Ausgangsstufe (φ₂, φ₃, ...) des Wellen-Schieberegisters (101) verbunden ist.

4. Schaltung gemäß Anspruch 3, gekennzeichnet durch
eine Treiberspannungsquelle (305), die mit der ersten, zweiten, dritten und vierten Treiberspannungsleitung (Vᵣ₁, Vᵣ₂, Vᵣ₃, Vᵣ₄) jeweils zum Anlegen von ersten, zweiten, dritten und vierten Treiberspannungssignalen (Vᵣ₁, Vᵣ₂, Vᵣ₃, Vᵣ₄) verbunden ist,
wobei die Treiberspannungsquelle (305) derart betriebsfähig ist, daß für ein ungerades Feld die ersten, zweiten und dritten Treiberspannungssignale (Vᵣ₁, Vᵣ₂, Vᵣ₃) aus jeweils gleichphasigen Folgen von regelmäßigen Impulsen (HDL1, HDL3, HDL5; HDL2, HDL4, HDL6; HDL3, HDL5, HDL7) bestehen, während das vierte Treiberspannungssignal (Vᵣ₄) in Ruhe ist, und daß für ein gerades Feld das erste Treiberspannungssignal (Vᵣ₁) in Ruhe ist, während die zweiten, dritten und vierten Treiberspannungssignale (Vᵣ₂, Vᵣ₃, Vᵣ₄) aus gleichphasigen Folgen von regelmäßigen Impulsen (HDL2, HDL4, HDL6; HDL3; HDL5, HDL7; HDL4, HDL6, HDL8) bestehen.

5. Lichtempfindliche Aufnahmevorrichtung mit:
einem in Zeilen und Spalten angeordneten Feld von Photozellen (C₁₁ bis Cₘₙ);
einer Vielzahl von Auswahlleitungen (HDL1, ..., HDLm), von denen jede mit einer jeweiligen Reihe (C₁₁ bis C₁ₙ, ..., Cₘ₁ bis Cₘₙ) der Photozellen (C₁₁ bis Cₘₙ) verbunden ist;
einer Treiberauswahlschaltung (301) gemäß Anspruch 1, deren Auswahlleitungsausgänge (HDL1 bis HDLm) mit den jeweiligen Auswahlleitungen (HDL1 bis HDLm) verbunden sind;
einer an das Wellen-Schieberegister (101) der Treiberauswahlschaltung angeschlossenen ersten Signalquelle (305) zum Zuführen von Synchronisations- und Taktgeberschiebesteuersignalen (φ_{VS}, φ_{V1}, φ_{V2}) zum Abtasten der Auswahlleitungen (HDL1 bis HDLM); und
einer mit den gemeinsamen Treiberspannungsleitungen (Vᵣ₁ bis Vᵣ₃; Vᵣ₁ bis Vᵣ₄) des Schalterfelds der Treiberauswahlschaltung verbundenen zweiten Signalquelle (305) zum Zuführen von Treiberspannungssignalen (Vᵣ₁ bis Vᵣ₃; Vᵣ₁ bis Vᵣ₃).

## Revendications

1. Circuit de sélection d'attaque (301) qui délivre en sortie des impulsions de balayage, ledit circuit comportant :
un registre à décalage (101) à ondulation ayant plusieurs étages de sortie (φ₁, φ₂, φ₃) ; et
un réseau de commutation (Q_{V1} à Q_{V3}) comprenant plusieurs premiers transistors (Q_{V1}) et plusieurs deuxièmes transistors (Q_{V3}), dans lequel :
chaque premier transistor (Q_{V1}) et chaque deuxième transistor (Q_{V2}) est connecté par sa grille à un étage de sortie respectif commun (φ₁, φ₂, φ₃,...) dudit registre à décalage à ondulation (101) ;
lesdits premiers transistors (Q_{V1}) sont connectés chacun entre une ligne commune (Vᵣ₁) d'une première tension d'attaque et une sortie de ligne de sélection respective (HDL1, HDL3, HDL5,...) dudit réseau de commutation (Q_{V1} à Q_{V3}) ; et
lesdits deuxièmes transistors (Q_{V2}) sont connectés chacun entre une ligne commune (Vᵣ₂) d'une seconde tension d'attaque et une sortie de ligne de sélection respective (HDL2, HDL4, HDL6,...) dudit réseau de commutation (Q_{V1} à Q_{V3}) ;
lequel circuit est caractérisé par :
plusieurs troisièmes transistors (Q_{V3}) ayant chacun une grille connectée audit étage de sortie respectif commun (φ₁, φ₂, φ₃,...), et chaque troisième transistor (Q_{V3}) étant connecté entre une ligne commune (Vᵣ₃) d'une troisième tension d'attaque et la sortie de ligne de sélection respective (HDL3, HDL5,...) qui est connectée à ce premier transistor (Q_{V1}) dont la grille est connectée à l'étage de sortie suivant (φ₂, φ₃) dudit registre à décalage à ondulation (101).

2. Circuit selon la revendication 1, comportant une source de tension d'attaque (305) connectée auxdites première, deuxième et troisième lignes de tension d'attaque (Vᵣ₁, Vᵣ₂, Vᵣ₃) pour leur appliquer respectivement des premier, deuxième et troisième signaux de tension d'attaque (Vᵣ₁, Vᵣ₂, Vᵣ₃), laquelle source (305) peut être actionnée afin que, pour une zone impaire, lesdits premier et deuxième signaux de tension d'attaque (Vᵣ₁, Vᵣ₂) consistent en séquences respectives, en phase, d'impulsions régulières (HDL1, HDL3, HDL5 ; HDL2, HDL4, HDL6) tandis que ledit troisième signal de tension d'attaque (Vᵣ₃) est au repos, et que pour une zone paire, ledit premier signal de tension d'attaque (Vᵣ₁) soit au repos tandis que lesdits deuxième et troisième signaux de tension d'attaque (Vᵣ₂, Vᵣ₃) consistent en séquences respectives, en phase, d'impulsions régulières (HDL2, HDL4, HDL6 ; HDL3, HDL5, HDL7).

3. Circuit selon la revendication 1, caractérisé en outre par :
plusieurs quatrièmes transistors (Qᵥ₄) ayant chacun une grille connectée audit étage de sortie commun respectif (φ₁, φ₂, φ₃,...), et chaque quatrième transistor (Qᵥ₄) étant connecté entre une quatrième ligne commune de tension d'attaque (Vᵣ₄) et la sortie de sélection respective (HDL4, HDL6, HDL8,...) qui est connectée au deuxième transistor (Qᵥ₂) dont la grille est connectée à l'étage de sortie suivant (φ₂, φ₃,...) dudit registre à décalage à ondulation (101).

4. Circuit selon la revendication 3, comportant une source (305) de tension d'attaque connectée auxdites première, deuxième, troisième et quatrième lignes de tension d'attaque (Vᵣ₁, Vᵣ₂, Vᵣ₃, Vᵣ₄) pour leur appliquer respectivement des premier, deuxième, troisième et quatrième signaux de tension d'attaque (Vᵣ₁, Vᵣ₂, Vᵣ₃, Vᵣ₄), laquelle source (305) peut être mise en oeuvre de manière que, pour une zone impaire, lesdits premier, deuxième et troisième signaux de tension d'attaque (Vᵣ₁, Vᵣ₂, Vᵣ₃) consistent en séquences respectives en phase d'impulsions régulières (HDL1, HDL3, HDL5 ; HDL2, HDL4, HDL6 ; HDL3, HDL5, HDL7) tandis que ledit quatrième signal de tension d'attaque (Vᵣ₄) est au repos, et que pour une zone paire, ledit premier signal de tension d'attaque (Vᵣ₁) soit au repos tandis que lesdits deuxième, troisième et quatrième signaux de tension d'attaque (Vᵣ₂, Vᵣ₃, Vᵣ₄) consistent en séquences respectives en phase d'impulsions régulières (HDL2, HDL4, HDL6 ; HDL3 ; HDL5, HDL7 ; HDL4, HDL6, HDL8).

5. Appareil capteur photosensible comportant :
un réseau de cellules photosensibles (C₁₁ à Cₘₙ) agencées en rangées et colonnes ;
une multiplicité de lignes de sélection (HDL1,..., HDLm) connectées chacune à une rangée respective (C₁₁ à C₁ₙ, ..., Cm1 à Cₘₙ) desdites cellules photosensibles (C₁₁ à Cₘₙ) ;
un circuit de sélection d'attaque (301), tel que revendiqué dans la revendication 1, dont les sorties de lignes de sélection (HDL1 à HDLm) sont connectées à certaines, respectives, desdites lignes de sélection (HDL1 à HDLm) ;
une première source de signaux (305) connectée au registre à décalage à ondulation (101) dudit circuit de sélection d'attaque pour lui fournir des signaux de synchronisation et de commande de décalage d'horloge (φ_{VS}, φ_{V1}, φ_{V2}) pour le balayage desdites lignes de sélection (HDL1 à HDLm) ; et
une seconde source (305) de signaux connectée aux lignes de tensions d'attaque communes (Vᵣ₁ à Vᵣ₃ ; Vᵣ₁ à Vᵣ₄) du réseau de commutation dudit circuit de sélection d'attaque pour lui appliquer des signaux de tension d'attaque (Vᵣ₁ à Vᵣ₃ ; Vr₁ à Vᵣ₃).
